# FASCICULE DE BREVET EUROPEEN

(11) **EP 1 615 488 B1**
(45) Date de publication et mention de la délivrance du brevet: **29.07.2009**
(21) Numéro de dépôt: 05291454.6
(22) Date de dépôt: 05.07.2005
(51) Int. Cl.: H05K 7/20, H05K 3/00

(54) **Assemblage électronique à drain thermique notamment pour module de commande de lampe à décharge de projecteurs de véhicule automobile**
Elektronische Baugruppe mit Wärmeabführung, insbesondere für Steuerungsmodul eines Kraftfahrzeugscheinwerfers
Electronic assembly with heat transfer, especially for a control module for a discharge head lamp of a vehicle

(30) Priorité: 09.07.2004 FR 0407725
(43) Date de publication de la demande: 11.01.2006
(73) Titulaire: VALEO VISION, 93012 Bobigny Cedex (FR)
(72) Inventeur: Duarte, Marc, 93250 Villemomble (FR); Nicolai, Jean-Marc, 92400 Courbevoie (FR); Myotte, David, 93360 Neuilly Plaisance (FR); Govin, Fabrice, 92400 Courbevoie (FR)

(56) Documents cités:
- EP-A- 0 291 400
- EP-A- 1 087 652
- EP-A- 1 392 088
- DE-A1- 10 102 848
- DE-A1- 19 826 023
- US-A- 5 766 740
- US-A- 6 084 776
- US-A1- 2002 141 150
- US-A1- 2004 066 643
- US-A1- 2004 120 129

## Description

La présente invention concerne un assemblage électronique à drain thermique notamment pour module de commande de lampe à décharge de projecteur de véhicule automobile. Dans l'état de la technique, on a déjà assemblé des circuits imprimés sur des substrats métalliques. Lorsque des circuits électroniques de puissance sont mis en fonctionnement sur le circuit imprimé, il se produit à la fois un environnement électromagnétique bruité et des chocs thermiques provoqués par de brusques variations de tension électrique et ou de courant électrique.

Dans un premier état de la technique présenté par le présent demandeur, notamment dans la demande EP 1.087.652, on a déjà décrit un perfectionnement aux assemblages électroniques à drain thermique. Dans de tels assemblages, une carte ou circuit imprimé relativement rigide est associée par un matériau thermiquement conducteur à une pièce ou semelle métallique qui permet d'évacuer l'énergie thermique dissipée sur le substrat du circuit imprimé. En particulier, dans ce premier état de la technique, la semelle métallique présente un pion de fixation au circuit imprimé à travers un perçage de celui-ci de sorte que, lorsque le pion est déformé à l'aide d'un outil lors de l'assemblage, le circuit imprimé et la semelle se trouvent solidarisés l'un à l'autre, d'une part, et un couplage thermique du circuit imprimé et de la semelle métallique par l'intermédiaire du matériau thermiquement conducteur et électriquement isolant est réalisé, d'autre part.

Malheureusement, ce premier état de la technique introduit plusieurs problèmes. Particulièrement, entre le circuit imprimé et le radiateur en aluminium, on comprime d'une manière contrôlée ou maîtrisée un matériau à deux composants, dont l'un est à base de silicone chargé tandis que l'autre est une trame à base de fibres de verre. Le premier matériau a pour fonction de produire une conduction thermique. Le second matériau a pour fonction de réaliser une isolation électrique. Particulièrement, le matériau à deux composants remplit l'espace vide entre la semelle métallique et le circuit imprimé.

La reprise de masse électrique entre la semelle métallique et une partie conductrice prévue du circuit imprimé est assurée par le rivetage du circuit imprimé sur sa semelle à l'aide du pion précité.

Il en résulte que la mise en oeuvre d'un tel matériau à deux composants est complexe et présente un coût élevé lors de la fabrication en grande série. Dans un second état de la technique, la fonction d'isolation électrique est assurée en surélevant le circuit imprimé par rapport à son radiateur, d'une valeur suffisante pour garantir l'isolation électrique ou la conduction thermique par la couche de fibres de verre. Les zones chaudes du circuit imprimé reçoivent en face inférieure un adhésif fin, simple face multicouche. Une couche de cuivre est prévue pour la conduction thermique tandis qu'une couche de type "capton" est prévue pour isolation électrique. Le contact entre le circuit imprimé d'une part et le radiateur d'autre part est assuré dans la seule zone chaude par une pâte thermique qui n'est pas électriquement isolante et qui remplit l'espace vide entre le radiateur et le circuit imprimé. Cette pâte permet notamment de réaliser une compensation des tolérances géométriques des pièces mécaniques. Le positionnement du circuit imprimé est assuré par les pions de centrage sur le radiateur. Son maintien et sa solidarisation sont assurés par écrasement de tampons élastomères fixés dans le couvercle du module. Le couvercle permet d'exécuter un appui du circuit imprimé sur le front du boîtier. La reprise de masse électrique est assurée par des billes en étain qui sont écrasés sur une partie conductrice prévue à cet effet du circuit imprimé lorsque le couvercle du module est serti sur son corps proprement dit.

Dans un troisième état de la technique, l'isolation électrique est assurée également par une couche d'air. Mais les zones chaudes du circuit imprimé bénéficient d'une dissipation thermique au moyen d'une matière tière à deux composants comme dans le premier état de la technique. Le circuit imprimé est solidarisé au radiateur par une vis et la solution de reprise de la masse électrique est à nouveau exécutée à l'aide de billes en étain.

L'ensemble de ces trois états de la technique précités propose donc des solutions d'un coût élevé. Du fait de la dissociation des fonctions de conduction thermique et d'isolation électrique notamment, les pièces sont multiples et les techniques d'assemblage sont aussi multiples. Il n'y a donc pas d'optimisations possibles du processus d'industrialisation. La publication EP 139 20 88 divulgue également un assemblage électronique à drain thermique.

À la différence, l'invention concerne un assemblage électronique à drain thermique tel que défini dans les revendications.

Selon d'autres aspects de l'invention :
- l'élément de fixation complémentaire est disposé en relation avec une zone conductrice du circuit imprimé ;
- l'élément de fixation coopère avec des perçages sur la couche complexe d'interface d'une part et le circuit imprimé d'autre part ;
- l'élément de fixation est constitué par un pion solidaire d'une face de fond du corps de boîtier, comme une saillie sur le fond du corps de boîtier et conformé de façon à se déformer sous l'action d'un outil et venir ainsi solidariser le corps de boîtier, la couche complexe d'interface et le circuit imprimé ;
- l'élément de fixation est en contact électrique avec un élément conducteur de reprise de masse sur le schéma de connexion électrique du circuit imprimé ;
- la couche complexe d'interface comporte en outre une couche de matériau conducteur thermique ;
- au moins une des couches est à la fois au moins isolant électrique et/ou conducteur thermique et/ou adhésive ;
- la partie supérieure du haut du pion de fixation est configurée de manière à :
   - effectuer le contact électrique de reprise de masse électrique avec la zone conductrice ;
   - effectuer un appui mécanique du circuit imprimé sur la couche complexe est sur le fond du boîtier;
   - assurer un couplage thermique par la suppression de tout espace d'air entre le circuit imprimé et le boîtier servant ainsi de radiateur thermique ;
- le fond du boîtier présente une forme concave, et le pion de fixation est disposé au centre du fond du boîtier (3) ;
- l'adhésif utilisé pour réaliser les couches adhésives (5, 6), est préférentiellement réalisé par une masse acrylique ;
- la couche d'isolant électrique présente une résistance thermique suffisamment faible pour remplir la fonction de dissipation thermique ;
- la couche d'isolant électrique est en polyester, en Polyéthylène Naphtalate (PEN) ou en poly imide.
- la couche complexe d'interface est dimensionnée en sorte que elle dépasse ou au moins soit tangente à au moins un bord du circuit imprimé ;
- les dimensions de la couche complexe d'interface sont supérieures à celles du circuit imprimé, de sorte que le bord de la couche complexe d'interface dépasse et peut être marouflé sur le bord en épaisseur du circuit imprimé ;
- la couche complexe d'interface, qui est interposée entre une face du circuit imprimé et une face du fond de boîtier, comporte en plus une couche conductrice, réalisée par une mince couche d'un métal conducteur, d'un film en un matériau polymère conducteur, ou d'une grille conductrice mince dont le motif est prédéterminé ;
- la couche conductrice est reliée électriquement à un potentiel de référence pour assurer une protection contre les perturbations électromagnétiques.
- le circuit imprimé porte au moins un circuit intégré de puissance qui coopère avec un trou du circuit imprimé par l'intermédiaire d'un élément de brasure ou d'une colle conductrice et qui présente une métallisation sous forme d'un via ;
- le via est de forme générale cylindrique terminée à son extrémité supérieure par une tête haute et à son extrémité inférieure par une tête basse réunies l'une l'autre par un corps cylindrique qui vient border l'épaisseur du perçage ;
- l'assemblage comporte une couche mince, qui a tendance à obstruer, lors de l'application du flux de chaleur pour faire fondre une pastille de brasure ou de colle conductrice, le perçage de sorte que la couche mince constitue un bouchon empêchant le coulage de la brasure en fusion ou de la colle conductrice ;
- la couche mince est un vernis réalisant la protection du circuit imprimé.
- le boîtier comporte un couvercle de fermeture qui comporte au moins un bras flexible doté d'une partie d'appui qui vient en contact intime avec un pavé conducteur qui appartient au schéma d'interconnexion et qui est relié au circuit de reprise de masse électrique sur le circuit imprimé, et le couvercle et le cas échéant le corps de boîtier sont réalisés en un matériau électriquement conducteur et le bras flexible présente une flexibilité contrôlée qui participe à la mise en appui de l'assemblage composé du circuit imprimé et de la couche complexe d'interface sur le fond, comme un fond concave du boîtier.

L'invention concerne enfin un module électronique, comme un module de commande de lampes à décharge pour un projecteur de véhicule automobile, caractérisé en ce qu'il comporte au moins un assemblage avec un drain thermique à couche complexe d'interface à deux couches d'adhésifs.

D'autres caractéristiques et avantages de la présente invention seront mieux compris à l'aide de la description et des figures annexées parmi lesquelles :
-- la figure 1 représente une vue en coupe d'un mode de réalisation de la présente invention ;
-- la figure 2 représente une demi vue en coupe d'un autre mode de réalisation de la présente invention ;
-- la figure 3 représente une vue schématique en coupe d'un autre mode de réalisation de la présente invention ;
-- la figure 4 représente une vue en coupe partielle d'un autre mode de réalisation de la présente invention ;
-- la figure 5 représente une vue en coupe d'un autre mode de réalisation de la présente invention.

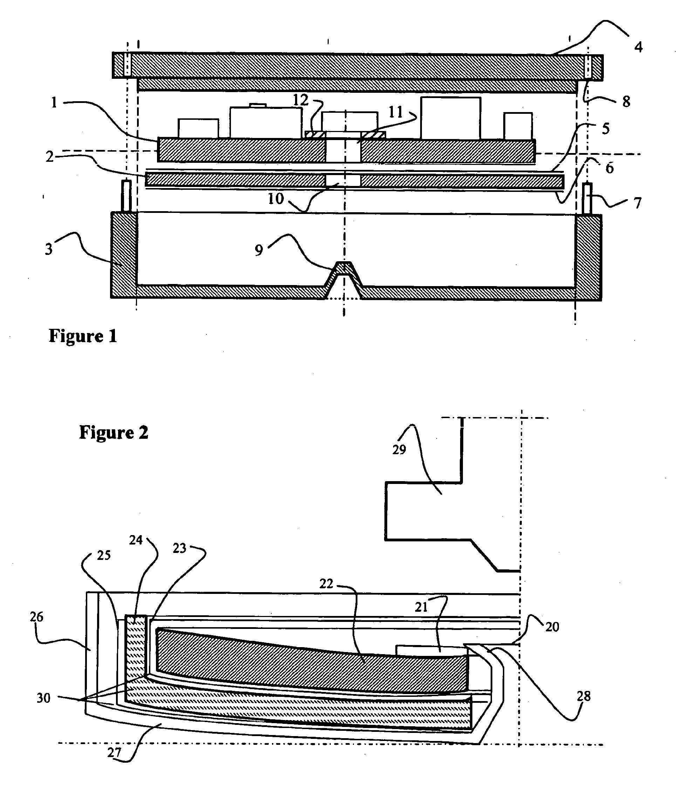

À la figure 1, on a représenté une vue en coupe schématique d'un mode de réalisation de la présente invention. Un circuit imprimé 1 comporte un substrat en un matériau synthétique. Le substrat du circuit imprimé porte, par exemple sur une seule de ses faces, plusieurs composants électroniques ou électriques comprenant notamment des circuits électroniques de puissance comme des transistors de puissance, des circuits électroniques de contrôle pour piloter ces composants électroniques de puissance, des composants passifs comme des résistances, des condensateurs, des connecteurs, .... Le substrat du circuit imprimé porte aussi une ou plusieurs couches d'un schéma électrique de connexion réalisées à l'aide de pistes conductrices, qui permettent de porter des broches de connexion de chacun des composants déposés sur le substrat à un potentiel électrique déterminé et ou de leur apporter des courants électriques déterminés.

Les dissipations thermiques produites par la circulation de courant électrique produisent localement des échauffements qui sont appliqués sur le substrat et qu'il est très important de dissiper pour éviter d'une part une détérioration des performances de fonctionnement du circuit électrique constitué par le schéma d'interconnexion et les composants et d'autre part une détérioration des qualités mécaniques du circuit imprimé proprement dit qui pourraient conduire à une destruction de la fonction de service assurée par l'assemblage.

Selon l'invention, le circuit imprimé est destiné à être monté sur une partie servant notamment de radiateur et de support, éventuellement aussi sous forme d'un boîtier servant de protection mécanique, tout en étant intercalé relativement à ce support à l'aide d'une couche complexe 2, 5, 6, qui sert à la fois à la conduction thermique et à l'isolation électrique du circuit imprimé avec le support radiateur 3.

Quand le support radiateur 3 sert aussi de protection mécanique, il est constitué en forme de boîtier et peut présenter notamment un couvercle supérieur 4 qui est destiné à venir s'engager sur des colonnettes comme la colonnette 7 qui, à travers des perçages, comme le perçage 8, permettent la solidarisation du corps de boîtier 3 et de son couvercle 4.

La solidarisation du circuit imprimé 1 avec la couche complexe d'interface 2, 5, 6 et avec le corps du boîtier 3, est assurée à l'aide d'un élément de fixation 9 qui passe à travers des perçages, respectivement 10 et 11, sur la couche complexe d'interface d'une part et le circuit imprimé 1 d'autre part. Selon l'invention, cet élément de fixation 9 est disposé en relation avec une zone, plutôt disposée au centre du circuit imprimé 1. Il peut être multiplié, c'est-à-dire qu'il peut y avoir plusieurs éléments de fixation comme l'élément de fixation 9.

Préférentiellement, l'élément de fixation 9 est constitué par un pion solitaire d'une face de fond du corps de boîtier 3. Le pion de fixation 9 peut être constitué par une saillie sur le fond du corps de boîtier 3. Préférentiellement, le pion de fixation 9 est conformé de façon, lorsque un outil de déformation (non représenté à la figure 1) le déforme, à s'aplatir et venir ainsi solidariser le corps de boîtier 3, la couche complexe d'interface 2, 5, 6 et le circuit imprimé 1.

Dans un mode préféré de réalisation, la couche complexe d'interface 2, 5, 6 est un élément composite qui comporte au moins, de haut en bas :
-- une première couche adhésive 5 qui permet de solidariser la couche complexe d'interface avec la majeure partie d'une face du circuit imprimé 1 ;
-- une couche d'un isolant électrique 2 ;
-- une seconde couche adhésive 6 qui permet de solidariser la couche complexe d'interface avec une partie importante de la face en regard du corps de boîtier 3,
une couche pouvant remplir plusieurs des fonctions ci-dessus à elle seule.

Dans la présente description, une telle couche complexe d'interface sera indifféremment appelée « drain thermique ».

Dans un exemple de procédé de fabrication d'un module électronique, comme un module de commande de lampes à décharge pour un projecteur de véhicule automobile, la pose des composants électriques, et l'implantation du schéma électrique d'interconnexion sont exécutées sur le circuit imprimé 1 qui est alors muni d'un perçage 11, pratiqué de préférence dans une zone centrale du circuit imprimé 1. Une piste ou zone conductrice 12 est réalisée sur la face supérieure du circuit imprimé 1 qui permet de connecter une reprise de masse électrique avec le schéma d'interconnexion précité.

La couche complexe d'interface est alors réalisée de manière à présenter la structure décrite ci-dessus, et elle est disposée à travers son perçage précité 10 sur le fond du boîtier en faisant traverser le pion 9 de fixation à travers le perçage 10.

Le circuit imprimé 1 est alors à son tour présenté par-dessus l'ouverture du corps de boîtier 3, de sorte que le perçage 11 puisse entourer le pion de fixation 9.

Pour réaliser une solidarisation permanente, un outil de déformation est alors introduit par l'ouverture visible à la partie supérieure du boîtier 3. Le haut du pion de fixation 9 est alors déformé par-dessus la zone conductrice 12 de reprise de masse électrique sur le circuit imprimé 1. L'effet de cette déformation de la partie supérieure du haut du pion de fixation 9 est alors :
-- d'effectuer le contact électrique de reprise de masse électrique avec la zone conductrice 12 ;
-- d'effectuer un appui mécanique du circuit imprimé 1 sur la couche complexe d'interface et sur le fond du boîtier 3 ;
-- d'assurer un couplage thermique par la suppression de tout espace d'air entre le circuit imprimé 1 et le boîtier 3 servant ainsi de radiateur thermique.

Ce dernier effet de couplage thermique est particulièrement assuré quand le circuit imprimé 1 présente une relative rigidité mécanique. En effet, la déformation du pion de fixation 9 applique une force d'appui permanente qui entraîne elle-même une tension de déformation dans l'ensemble du circuit imprimé et l'applique sur le fond du corps de boîtier 3.

L'adhésif utilisé pour réaliser les couches adhésives respectivement 5 et 6, est préférentiellement réalisé par une masse acrylique. La couche de conduction thermique 2 est constituée par un matériau qui est aussi un isolant électrique et qui est préférentiellement un polyester. En effet, il existe une classe de polyesters qui présente une résistance thermique suffisamment faible pour remplir la fonction de dissipation thermique.

Préférentiellement, la couche complexe d'interface 2, 5, 6 est dimensionnée en sorte que, après l'opération de déformation du pion de fixation 9, elle dépasse ou au moins soit tangente au bord du circuit imprimé 1.

Préférentiellement, la face supérieure de contact du fond de boîtier 9 avec la couche complexe 2, 5, 6 est plate, de sorte que le contact puisse porter sur la plus grande surface possible. Cependant, dans d'autres applications, la forme de la face supérieure de contact du fond de boîtier 9 peut affecter des formes complexes, notamment avec des cuvettes, au fond desquelles il n'y aura pas de contact. Une telle conformation n'est pas indiquée au dessin.

À la figure 2, on a représenté un tel autre mode de réalisation dans une demi vue en coupe. On a représenté seulement le corps de boîtier qui présente un flanc vertical 26 raccordé à un fond concave 27. Le centre du fond concave 27 présente un pion de fixation 20 qui affecte la forme d'une colonne de forme creuse.

La couche complexe d'interface comporte une première couche adhésive 25, une couche isolante 24 et une seconde couche adhésive 23. Elle est placée entre le fond concave 27 et une face inférieure du circuit imprimé 22. Dans ce mode particulier de réalisation, une seconde disposition est prise conformément à l'invention selon laquelle les dimensions de la couche complexe d'interface sont supérieures à celles du circuit imprimé 22, de sorte que le bord de la couche complexe d'interface dépasse et peut être marouflé sur le bord en épaisseur du circuit imprimé 22. Le circuit imprimé 22 présente selon l'invention un perçage central qui correspond au perçage central de la couche complexe d'interface et une piste de reprise de masse électrique 21. La colonne servant de pion de fixation 20 peut alors subir l'écrasement d'un outil de déformation 29 pour la tête s'engage dans la partie creuse de la colonne 20 de sorte que le haut de la colonne 20 s'élargisse en tronc de cône élargi 28 en haut qui vient en appui sur le haut de la face de la piste de reprise de masse 21, et qui déforme l'assemblage le long du fond concave 27. On assure ainsi :
-- une déformation permanente qui permet d'appui toutes les surfaces les unes aux autres ;
-- un couplage thermique correct.

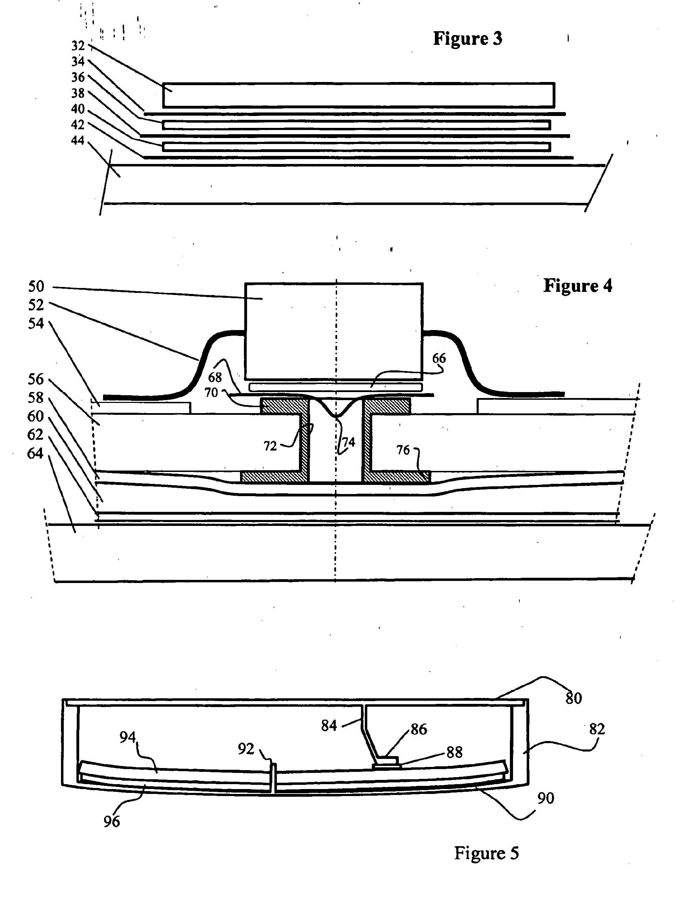

À la figure 3, on a représenté une vue schématique en coupe d'un autre mode de réalisation de la présente invention. Selon ce mode de réalisation, la couche complexe d'interface qui est interposée entre une face du circuit imprimé et une face du fond de boîtier, comporte en plus une couche conductrice électriquement. Une telle couche conductrice peut être réalisée par une mince couche d'un métal conducteur, d'un film en un matériau polymère conducteur, d'une grille conductrice mince dont le motif est prédéterminé.

On a représenté à la figure 3, la succession de l'assemblage qui est, de haut en bas, composé de :
-- le circuit imprimé proprement dit 32 ;
-- un film adhésif 34 ;
-- une couche conductrice de la chaleur 36 ;
-- un film adhésif 38 ;
-- une couche constituée en un matériau conducteur thermique et isolant électrique 40 ;
-- un film adhésif 42 ;
-- la face de contact du fond de boîtier 44,
une des couches 32, 34, 36, 38, 40 et 42 pouvant remplir plusieurs des fonctions ci-dessus à elle seule, c'est-à-dire être à la fois au moins isolant électrique et/ou conducteur thermique et/ou adhésive.

À la figure 4, on a représenté un autre mode de réalisation de l'invention sous forme d'une demi vue en coupe schématique.

Un circuit intégré de puissance 50 présente deux rangées de bornes constituées par le pliage d'une grille qui est destinée à venir en contact avec des pavés de soudage sur le schéma d'interconnexion électrique déposée sur une face du circuit imprimé 56. On a représenté une patte 52 de connexion du circuit intégré de puissance 50 avec un pavé conducteur 54 du schéma d'interconnexion électrique précité. Afin d'améliorer le transfert thermique de la chaleur produite par le circuit intégré de puissance 50, on dispose un trou au droit du boîtier du circuit intégré 50 qui traverse entièrement le circuit imprimé 56 et qui présente une métallisation sous forme d'un via. Un tel via est de forme générale cylindrique terminée à son extrémité supérieure par une tête haute 70 et à son extrémité inférieure par une tête basse 76. Les têtes haute 70 et basse 76 sont réunies l'une à l'autre par un corps cylindrique 72 qui vient border l'épaisseur du perçage. Il en résulte deux caractéristiques difficiles à mettre en oeuvre :
-- tout d'abord, les têtes haute 70 et basse 76 constituent des épaisseurs qui ont tendance, particulièrement pour la tête basse 76, à déformer la couche complexe d'interface, composée du film adhésif 58, la couche isolante électrique et conductrice thermique 65 et du second film adhésif 62 qui vient en contact avec le fond de boîtier 64 ; il n'y a donc plus un bon couplage thermique entre la face du circuit imprimé et la couche d'interface justement dans une zone thermique chaude ;
-- ensuite, le via thermique est creux dans son épaisseur cylindrique 72 ;
   or, pour réaliser un bon contact thermique et une fixation mécanique du boîtier du circuit intégré 50 sur la circuit imprimé proprement dit, il est connu de déposer une pastille 66 de brasure sur le via thermique 70, 72 et 76 de sorte que, en appliquant un flux thermique de soudage, la brasure 66 puisse fondre et souder le fond de boîtier du circuit intégré 50 à la surface du via. Cependant, dans ce type de réalisation, la brasure a tendance à couler à l'intérieur du via cylindrique 72 de sorte que un fluide d'un matériau brûlant pourrait venir en contact, notamment avec le premier film adhésif 65, puis le cas échéant , percer la couche isolante 62.

Pour porter remède à cet inconvénient, l'invention propose de déposer un film ou une couche mince 68 thermiquement dégradable, qui a tendance à obstruer, lors de l'application du flux de chaleur pour faire fondre la brasure 66, le perçage 72 dans le via de sorte que le vernis de protection du circuit imprimé constitue un bouchon empêchant le coulage de la brasure en fusion. Cependant, le vernis utilisé est volatilisé sur la surface du circuit imprimé 56 de sorte que le contact de la brasure 66 en fusion avec la surface du circuit imprimé 56 est correct. En variante, au lieu d'utiliser une brasure 66, on pourra utiliser une colle conductrice.

À la figure 5, on a représenté un autre mode de réalisation de l'invention sous forme d'une demi vue en coupe schématique.

L'assemblage de ce mode de réalisation de l'invention est constitué dans un boîtier fermé comportant un couvercle 80 et un corps de boîtier comportant des flancs latéraux verticaux 82 et un fond horizontal 90 de forme concave. Le couvercle 80 peut être relié au corps 82, 90 de manière étanche par tout moyen de solidarisation connu. Le moyen de fixation 92 traverse la couche complexe d'interface 96 ainsi que le circuit imprimé 94 sur lequel on n'a pas représenté de composants électriques particuliers. On note à cette occasion, que le circuit imprimé est généralement doté d'au moins un connecteur qui doit rester accessible en dehors du boîtier par une ouverture de celui-ci, en général sur un bord vertical 82, protégé le cas échéant par un volet non représenté.

Selon l'invention, le couvercle 80 du boîtier comporte au moins un bras flexible 84 doté d'une partie d'appui 86 qui vient en contact intime avec un pavé conducteur 88 qui appartient au schéma d'interconnexion et qui est relié au circuit de reprise de masse électrique sur le circuit imprimé 94. Dans ce cas, le couvercle et le cas échéant le corps de boîtier sont réalisés en un matériau électriquement conducteur et le bras flexible présente une flexibilité contrôlée qui participe à la mise en appui de l'assemblage composé du circuit imprimé 94 et de la couche complexe d'interface 96 sur le fond 90 concave du boîtier.

## Revendications

1. Assemblage électronique à drain thermique qui comporte essentiellement un circuit imprimé (1 ; 22 ; 32 ; 56 ; 94) et un boîtier (3, 4 ; 26, 27 ; 44 ; 64 ; 80, 82, 90) pouvant servir pour la conduction thermique et pour l'isolement électrique et qui comporte une couche complexe d'interface (2, 5, 6 ; 23 - 25 ; 34 - 42 ; 58 - 62 ; 96),
- la couche complexe d'interface étant intercalée entre au moins une face du circuit imprimé et une face du boîtier,
- la couche complexe d'interface s'étendant sur une partie majoritaire de la face du circuit imprimé et comportant
o une première couche adhésive (5) qui permet de solidariser la couche complexe (2, 5, 6) avec la majeure partie d'une face du circuit imprimé (1) ;
o une couche d'un isolant électrique (2) présentant une résistance thermique suffisamment faible pour remplir la fonction de dissipation thermique;
o une seconde couche adhésive (6) qui permet de solidariser la couche complexe d'interface (2, 5, 6) avec une partie importante de la face en regard du corps de boîtier (3),
- l'assemblage comportant au moins un élément de fixation complémentaire (9) pour la solidarisation du circuit imprimé (1) avec la couche complexe d'interface (2, 5, 6) et avec le corps du boîtier (3),
- le circuit imprimé (1) présentant une relative rigidité mécanique, la configuration mutuelle de l'élément de fixation (9) et de la forme du fond du boîtier (3) résultant en une force d'appui permanente qui entraîne elle-même une tension de déformation dans l'ensemble du circuit imprimé (1) et l'applique sur le fond du corps de boîtier (3).

2. Assemblage selon la revendication 1, **caractérisé en ce que** l'élément de fixation complémentaire (9) est disposé en relation avec une zone conductrice du circuit imprimé (1).

3. Assemblage selon la revendication 2, **caractérisé en ce que** l'élément de fixation (9) coopère avec des perçages (10, 11), sur la couche complexe d'interface (2, 5, 6) d'une part et le circuit imprimé (1) d'autre part.

4. Assemblage selon la revendication 2 ou 3, **caractérisé en ce que** l'élément de fixation (9) est constitué par un pion solidaire d'une face de fond du corps de boîtier (3), comme une saillie sur le fond du corps de boîtier (3) et conformé de façon à se déformer sous l'action d'un outil et venir ainsi solidariser le corps de boîtier 3, la couche complexe d'interface (2, 5, 6) et le circuit imprimé (1).

5. Assemblage selon la revendication 1, **caractérisé en ce que** l'élément de fixation (9) est en contact électrique avec un élément conducteur (12 ; 21) de reprise de masse sur le schéma de connexion électrique du circuit imprimé (1 ; 22).

6. Assemblage selon la revendication 1, **caractérisé en ce que** la couche complexe d'interface comporte en outre une couche de matériau conducteur thermique.

7. Assemblage selon l'une des revendications 1 ou 6, **caractérisé en ce que** au moins une des couches est à la fois au moins isolant électrique et/ou conducteur thermique et/ou adhésive.

8. Assemblage selon la revendication 5, **caractérisé en ce que** la partie supérieure du haut du pion de fixation 9 est configurée de manière à :
-- effectuer le contact électrique de reprise de masse électrique avec la zone conductrice (12) ;
-- effectuer un appui mécanique du circuit imprimé (1) sur la couche complexe (2, 5, 6) est sur le fond du boîtier (3) ;
-- assurer un couplage thermique par la suppression de tout espace d'air entre le circuit imprimé (1) et le boîtier (3) servant ainsi de radiateur thermique.

9. Assemblage selon la revendication 1, **caractérisé en ce que** le fond du boîtier (3) présente une forme concave, et **en ce que** le pion de fixation (9) est disposé au centre du fond du boîtier (3).

10. Assemblage selon la revendication 1, **caractérisé en ce que** l'adhésif utilisé pour réaliser les couches adhésives (5, 6), est préférentiellement réalisé par une masse acrylique.

11. Assemblage selon la revendication 1, **caractérisé en ce que** la couche d'isolant électrique (2) est en polyester, en Polyéthylène Naphtalate (PEN) ou en poly imide.

12. Assemblage selon l'une quelconque des revendications précédentes , **caractérisé en ce que** la couche complexe d'interface (2, 5, 6) est dimensionnée en sorte que elle dépasse ou au moins soit tangente à au moins un bord du circuit imprimé (1).

13. Assemblage selon l'une quelconque des revendications 9 ou 12, **caractérisé en ce que** les dimensions de la couche complexe d'interface sont supérieures à celles du circuit imprimé (22), de sorte que le bord de la couche complexe d'interface dépasse et peut être marouflé sur le bord en épaisseur du circuit imprimé (22).

14. Assemblage selon l'une quelconque des revendications précédentes, **caractérisé en ce que** la couche complexe d'interface (2, 5, 6), qui est interposée entre une face du circuit imprimé et une face du fond de boîtier, comporte en plus une couche conductrice, réalisée par une mince couche d'un métal conducteur, d'un film en un matériau polymère conducteur, ou d'une grille conductrice mince dont le motif est prédéterminé.

15. Assemblage selon la revendication 14, **caractérisé en ce que** la couche conductrice est reliée électriquement à un potentiel de référence pour assurer une protection contre les perturbations électromagnétiques.

16. Assemblage selon l'une quelconque des revendications précédentes, **caractérisé en ce que** le circuit imprimé (56) porte au moins un circuit intégré de puissance (50) qui coopère avec un trou du circuit imprimé (56) par l'intermédiaire d'un élément de brasure ou d'une colle conductrice et qui présente une métallisation sous forme d'un via.

17. Assemblage selon la revendication 16, **caractérisé en ce que** le via est de forme générale cylindrique terminée à son extrémité supérieure par une tête haute (70) et à son extrémité inférieure par une tête basse (76) réunies l'une l'autre par un corps cylindrique (72) qui vient border l'épaisseur du perçage.

18. Assemblage selon la revendication 17, **caractérisé en ce qu'**il comporte une couche mince (68), qui a tendance à obstruer, lors de l'application du flux de chaleur pour faire fondre une pastille de brasure ou de colle conductrice (66), le perçage (72) de sorte que la couche mince constitue un bouchon empêchant le coulage de la brasure en fusion ou de la colle conductrice.

19. Assemblage selon la revendication 18, **caractérisé en ce que** la couche mince est un vernis réalisant la protection du circuit imprimé.

20. Assemblage selon l'une quelconque des revendications précédentes **caractérisé en ce que** le boîtier comporte un couvercle de fermeture (80) qui comporte au moins un bras flexible (84) doté d'une partie d'appui (86) qui vient en contact intime avec un pavé conducteur (88) qui appartient au schéma d'interconnexion et qui est relié au circuit de reprise de masse électrique sur le circuit imprimé (94), et **en ce que** le couvercle et le cas échéant le corps de boîtier (82, 90) sont réalisés en un matériau électriquement conducteur et le bras flexible présente une flexibilité contrôlée qui participe à la mise en appui de l'assemblage composé du circuit imprimé (94) et de la couche complexe d'interface (96) sur le fond (90), comme un fond concave du boîtier.

21. Module électronique, comme un module de commande de lampes à décharge pour un projecteur de véhicule automobile, **caractérisé en ce qu'**il comporte au moins un assemblage avec un drain thermique à couche complexe d'interface à deux couches d'adhésifs selon l'une quelconque des revendications précédentes.

## Claims

1. Electronic assembly with a thermal drain which substantially comprises a printed circuit (1; 22; 32; 56; 94) and a case (3, 4; 26, 27; 44; 64; 80; 82; 90) which can be used for thermal conduction and electrical insulation, and which comprises a complex interface layer (2, 5, 6; 23 - 25; 34 - 42; 58 - 62; 96),
- the complex interface layer being interposed between at least one surface of the printed circuit and a surface of the case;
- the complex interface layer extending over the largest part of the surface of the printed circuit, and comprising:
o a first adhesive layer (5) which makes it possible to render the complex layer (2, 5, 6) integral with the largest part of a surface of the printed circuit (1);
o a layer of an electrical insulator (2) with thermal resistance which is low enough to fulfil the function of thermal dissipation;
o a second adhesive layer (6) which makes it possible to render the complex interface layer (2, 5, 6) integral with a substantial part of the surface opposite the body of the case (3);
- the assembly comprising at least one complementary securing element (9) to render the printed circuit (1) integral with the complex interface layer (2, 5, 6) and with the body of the case (3); and
- the printed circuit (1) having relative mechanical strength, the mutual configuration of the securing element (9) and the form of the base of the case (3) resulting in a permanent support force which itself gives rise to a deformation tension in the printed circuit (1) as a whole, and applies this to the base of the body of the case (3).

2. Assembly according to claim 1, **characterised in that** the complementary securing element (9) is disposed in relation with a conductive area of the printed circuit (1).

3. Assembly according to claim 2, **characterised in that** the securing element (9) co-operates with opening (10, 11) in the complex interface layer (2, 5, 6) on the one hand, and the printed circuit (1) on the other hand.

4. Assembly according to claim 2 or claim 3, **characterised in that** the securing element (9) is constituted by a pin which is integral with a base surface of the body of the case (3), such as a projection which is on the base of the body of the case (3), and is formed so as to be deformed under the action of a tool, and thus to render integral the body of the case (3), the complex interface layer (2, 5, 6) and the printed circuit (1).

5. Assembly according to claim 1, **characterised in that** the securing element (9) is in electrical contact with a conductor element (12; 21) for earthing on the electrical connection diagram of the printed circuit (1; 22).

6. Assembly according to claim 1, **characterised in that** the complex interface layer additionally comprises a layer of thermally conductive material.

7. Assembly according to one of claims 1 or 6, **characterised in that** at least one of the layers is at the same time at least electrically insulating and/or thermally conductive and/or adhesive.

8. Assembly according to claim 5, **characterised in that** the upper part of the top of the securing pin 9 is configured such as to:
- provide the electrical contact for electrical earthing, with the conductive area (12);
- provide a mechanical support for the printed circuit (1) on the complex layer (2, 5, 6) and on the base of the case (3);
- assure thermal coupling by means of elimination of any air gap between the printed circuit (1) and the case (3), thus acting as a thermal radiator.

9. Assembly according to claim 1, **characterised in that** the base of the case (3) has a concave form, and **in that** the securing pin (9) is disposed in the centre of the base of the case (3).

10. Assembly according to claim 1, **characterised in that** the adhesive which is used to produce the adhesive layers (5, 6) is preferably formed by an acrylic mass.

11. Assembly according to claim 1, **characterised in that** the electrically insulating layer (2) is made of polyester, polyethylene naphthalate (PEN) or polyimide.

12. Assembly according to any one of the preceding claims, **characterised in that** the complex interface layer (2, 5, 6) has dimensions such that it extends beyond, or is at least tangent to at least one edge of the printed circuit (1).

13. Assembly according to either of claims 9 or 12, **characterised in that** the dimensions of the complex interface layer are larger than those of the printed circuit (22), such that the edge of the complex interface layer extends beyond, and can be pasted onto, the thickness of the printed circuit (22).

14. Assembly according to any one of the preceding claims, **characterised in that** the complex interface layer (2, 5, 6), which is interposed between a surface of the printed circuit and a surface of the base of the case, additionally comprises a conductive layer, which is provided by a thin layer of a conductive metal, a film of conductive polymer material, or a thin conductive grid, the pattern of which is predetermined.

15. Assembly according to claim 14, **characterised in that** the conductive layer is connected electrically to a reference potential, in order to assure protection against electromagnetic disturbances.

16. Assembly according to any one of the preceding claims, **characterised in that** the printed circuit (56) bears at least one integrated power circuit (50) which co-operates with a hole in the printed circuit (56) by means of a solder element or a conductive glue, and has metallisation in the form of a passage.

17. Assembly according to claim 16, **characterised in that** the passage has a generally cylindrical form which ends at its upper end in a top head (70) and at its lower end in a bottom head (76) which are connected to one another by a cylindrical body (72) which borders the thickness of the opening.

18. Assembly according to claim 17, **characterised in that** it comprises a thin layer (68) which, during application of the flow of heat to melt a pellet of solder or conductive glue (66), tends to obstruct the opening (72) such that the thin layer constitutes a stopper which prevents the solder or conductive glue which is melting from leaking.

19. Assembly according to claim 18, **characterised in that** the thin layer is a varnish which protects the printed circuit.

20. Assembly according to any one of the preceding claims, **characterised in that** the case comprises a closing cover (80) which comprises at least one flexible arm (84) provided with a support part (86) which comes into close contact with a conductive block (88) which belongs to the interconnection diagram, and is connected to the electrical earthing circuit on the printed circuit (94), and **in that** the cover, and if applicable the body of the case (82, 90), are made of an electrically conductive material, and the flexible arm has controlled flexibility which participates in the support of the assembly constituted by the printed circuit (94) and the complex interface layer (96) on the base (90), as a concave base of the case.

21. Electronic module, such as a control module for discharge lamps for a motor vehicle headlight, **characterised in that** it comprises at least one assembly with a thermal drain with a complex interface layer with two adhesive layers, according to any one of the preceding claims.

## Patentansprüche

1. Baugruppe mit Wärmesenke, die im Wesentlichen eine gedruckte Schaltung (1; 22; 32; 56; 94) und ein Gehäuse (3, 4; 26, 27; 44; 64; 80, 82, 90) umfasst, das zur Wärmeleitung und zur elektrischen Isolierung dienen kann, und die eine komplexe Grenzflächenschicht (2, 5, 6; 23-25; 34-42; 58-62; 96) umfasst, wobei
- die komplexe Grenzflächenschicht zwischen wenigstens einer Seite der gedruckten Schaltung und einer Seite des Gehäuses eingefügt ist,
- die komplexe Grenzflächenschicht sich über den größten Teil der Seite der gedruckten Schaltung erstreckt und aufweist:
o eine erste Klebeschicht (5), die ein festes Verbinden der komplexen Schicht (2, 5, 6) mit dem überwiegenden Teil einer Seite der gedruckten Schaltung (1) erlaubt;
o eine Schicht eines elektrischen Isoliermaterials (2), das einen Wärmewiderstand aufweist, der klein genug ist, um die Funktion der Wärmeableitung zu erfüllen;
o eine zweite Klebeschicht (6), die ein festes Verbinden der komplexen Grenzflächenschicht (2, 5, 6) mit einem großen Teil der gegenüberliegenden Seite des Gehäusekorpus (3) erlaubt,
- die Baugruppe wenigstens ein komplementäres Befestigungselement (9) zur festen Verbindung der gedruckten Schaltung (1) mit der komplexen Grenzflächenschicht (2, 5, 6) und mit dem Gehäusekorpus (3) umfasst,
- die gedruckte Schaltung (1) eine relative mechanische Steifigkeit aufweist, wobei die wechselseitige Ausbildung des Befestigungselements (9) und der Bodenform des Gehäuses (3) in einer permanenten Druckauflagekraft resultiert, die in der gesamten gedruckten Schaltung (1) eine Verformungsspannung bewirkt und diese auf den Boden des Gehäusekorpus (3) aufbringt.

2. Baugruppe nach Anspruch 1,
**dadurch gekennzeichnet, dass** das komplementäre Befestigungselement (9) im Zusammenhang mit einem leitenden Bereich der gedruckten Schaltung (1) angeordnet ist.

3. Baugruppe nach Anspruch 2,
**dadurch gekennzeichnet, dass** das Befestigungselement (9) mit Bohrungen (10, 11) in der komplexen Grenzflächenschicht (2, 5, 6) einerseits und der gedruckten Schaltung (1) andererseits zusammenwirkt.

4. Baugruppe nach Anspruch 2 oder 3,
**dadurch gekennzeichnet, dass** das Befestigungselement (9) durch einen mit einer Bodenfläche des Gehäusekorpus (3) fest verbundenen Stift gebildet ist, wie etwa ein Vorsprung auf dem Boden des Gehäusekorpus (3), und solchermaßen ausgebildet ist, dass er sich unter der Einwirkung eines Werkzeugs verformt und dabei den Gehäusekorpus (3), die komplexe Grenzflächenschicht (2, 5, 6) und die gedruckte Schaltung (1) fest miteinander verbindet.

5. Baugruppe nach Anspruch 1,
**dadurch gekennzeichnet, dass** das Befestigungselement (9) in elektrischem Kontakt mit einem leitenden Element (12; 21) zur Masseverbindung auf dem Verdrahtungsplan der gedruckten Schaltung (1; 22) ist.

6. Baugruppe nach Anspruch 1,
**dadurch gekennzeichnet, dass** die komplexe Grenzflächenschicht ferner eine Schicht aus wärmeleitendem Werkstoff aufweist.

7. Baugruppe nach einem der Ansprüche 1 oder 6,
**dadurch gekennzeichnet, dass** wenigstens eine der Schichten zugleich wenigstens elektrisch isolierend und/oder wärmeleitend und/oder klebend ist.

8. Baugruppe nach Anspruch 5,
**dadurch gekennzeichnet, dass** die Oberseite des oberen Teils des Befestigungsstifts (9) dazu ausgebildet ist,
-- den elektrischen Kontakt zur Masseverbindung mit dem leitenden Bereich (12) herzustellen;
-- eine mechanische Anlage der gedruckten Schaltung (1) auf der komplexen Schicht (2, 5, 6) und dem Boden des Gehäuses (3) zu bewirken;
-- eine thermische Kopplung durch die Beseitigung jeglichen Luftzwischenraums zwischen der gedruckten Schaltung (1) und dem als Kühlkörper dienenden Gehäuse (3) sicherzustellen.

9. Baugruppe nach Anspruch 1,
**dadurch gekennzeichnet, dass** der Boden des Gehäuses (3) eine konkave Form aufweist, und dass der Befestigungsstift (9) in der Mitte des Bodens des Gehäuses (3) angeordnet ist.

10. Baugruppe nach Anspruch 1,
**dadurch gekennzeichnet, dass** der zum Ausführen der Klebeschichten (5, 6) verwendete Kleber vorzugsweise aus einer Acrylmasse besteht.

11. Baugruppe nach Anspruch 1,
**dadurch gekennzeichnet, dass** die elektrische Isolierschicht (2) aus Polyester, Polyethylennaphtalat (PEN) oder Polyimid besteht.

12. Baugruppe nach einem der vorhergehenden Ansprüche,
**dadurch gekennzeichnet, dass** die komplexe Grenzflächenschicht (2, 5, 6) solchermaßen dimensioniert ist, dass sie über wenigstens einen Rand der gedruckten Schaltung (1) hinausreicht oder diesen zumindest tangiert.

13. Baugruppe nach einem der Ansprüche 9 oder 12,
**dadurch gekennzeichnet, dass** die Maße der komplexen Grenzflächenschicht größer sind als die der gedruckten Schaltung (22), so dass die komplexe Grenzflächenschicht in der Dicke über den Rand der gedruckten Schaltung (22) hinausreicht und auf diese aufgeklebt werden kann.

14. Baugruppe nach einem der vorhergehenden Ansprüche,
**dadurch gekennzeichnet, dass** die komplexe Grenzflächenschicht (2, 5, 6), die zwischen einer Seite der gedruckten Schaltung und einer Seite des Gehäusebodens eingefügt ist, ferner eine leitende Schicht umfasst, die durch eine dünne Schicht aus leitendem Metall, einen Film aus leitendem Polymermaterial oder ein dünnes leitendes Gitter realisiert ist, dessen Muster vorbestimmt ist.

15. Baugruppe nach Anspruch 14,
**dadurch gekennzeichnet, dass** die leitende Schicht elektrisch mit einem Bezugspotential verbunden ist, um einen Schutz vor elektromagnetischen Störungen zu gewährleisten.

16. Baugruppe nach einem der vorhergehenden Ansprüche,
**dadurch gekennzeichnet, dass** die gedruckte Schaltung (56) wenigstens eine integrierte Leistungsschaltung (50) trägt, die mit einem Loch der gedruckten Schaltung (56) mittels eines Lötelements oder eines leitfähigen Klebers zusammenwirkt und die eine Metallisierung in Form einer Durchkontaktierung aufweist.

17. Baugruppe nach Anspruch 16,
**dadurch gekennzeichnet, dass** die Durchkontaktierung eine allgemein zylindrische Form hat, die an ihrem oberen Ende in einem oberen Kopf (70) und an ihrem unteren Ende in einem unteren Kopf (76) endet, die beide durch einen zylindrischen Körper (72) miteinander verbunden sind, welcher die Dicke der Bohrung säumt.

18. Baugruppe nach Anspruch 17,
**dadurch gekennzeichnet, dass** sie eine dünne Schicht (68) umfasst, die dazu neigt, beim Anlegen des Wärmestroms zum Schmelzen eines Lötauges oder eines leitfähigen Klebeplättchens (66), die Bohrung (72) solchermaßen zu verschließen, dass die dünne Schicht einen Stopfen bildet, welcher das Ausbreiten des Schmelzlötmittels oder des leitfähigen Klebers verhindert.

19. Baugruppe nach Anspruch 18,
**dadurch gekennzeichnet, dass** die dünne Schicht ein die gedruckte Schaltung schützender Lack ist.

20. Baugruppe nach einem der vorhergehenden Ansprüche,
**dadurch gekennzeichnet, dass** das Gehäuse einen Verschlussdeckel (80) umfasst, der wenigstens einen flexiblen Arm (84) aufweist, der mit einem Auflageteil (86) versehen ist, das in innigem Kontakt mit einem leitfähigen Feld (88) gelangt, das zu dem Verdrahtungsplan gehört und das mit dem Massekreis auf der gedruckten Schaltung (94) verbunden ist, und dass der Deckel und gegebenenfalls der Gehäusekorpus (82, 90) aus einem elektrisch leitenden Material ausgeführt sind und der flexible Arm eine kontrollierte Biegsamkeit aufweist, die mitwirkt an der Anlage der aus der gedruckten Schaltung (94) und der komplexen Grenzflächenschicht (96) bestehenden Baugruppe am Boden (90), wie einem konkaven Boden des Gehäuses.

21. Elektronisches Modul, etwa ein Steuermodul für Gasentladungslampen für einen Kraftfahrzeugscheinwerfer,
**dadurch gekennzeichnet, dass** es wenigstens eine Baugruppe mit einer Wärmesenke mit komplexer Grenzflächenschicht mit zwei Klebeschichten nach einem der vorhergehenden Ansprüche umfasst.
